# EUROPEAN PATENT SPECIFICATION

(11) **EP 1 378 039 B1**
(45) Date of publication and mention of the grant of the patent: **04.05.2005**
(21) Application number: 02701506.4
(22) Date of filing: 08.03.2002
(51) Int. Cl.: H01S 5/183

(54) **VERTICAL CAVITY SURFACE EMITTING LASER**
OBERFLÄCHENEMITTIERENDER LASER MIT VERTIKALEM RESONATOR
LASER A CAVITE VERTICALE ET A EMISSION PAR SURFACE

(30) Priority: 15.03.2001 US 809236; 15.03.2001 US 809239
(43) Date of publication of application: 07.01.2004
(73) Proprietor: ECOLE POLYTECHNIQUE FEDERALE DE LAUSANNE, 1015 Lausanne (CH)
(72) Inventor: KAPON, Elyahou, CH-1018 Lausanne (CH); IAKOVLEV, Vladimir, CH-1024 Ecublens (CH); SIRBU, Alexei, CH-1024 Ecublens (CH); RUDRA, Alok, CH-1807 Blonay (CH)
(74) Representative: P&TS Patents & Technology Surveys SA
(86) International application number: PCT/IB2002/000683
(87) International publication number: WO 2002/075868

(56) References cited:
- WO-A-98/07218
- WO-A-98/08278
- WO-A-98/48492
- US-A- 5 513 204
- US-A- 5 977 604
- US-A- 5 985 686
- SYRBU A V ET AL: "30 DEG C CW operation of 1.52 µm InGaAsP/AlGaAs vertical cavity lasers with in situ built-in lateral current confinement by localised fusion" ELECTRONICS LETTERS, IEE STEVENAGE, GB, vol. 34, no. 18, 3 September 1998 (1998-09-03), pages 1744-1745, XP006010248 ISSN: 0013-5194
- NAKAGAWA S ET AL: "88øC, CONTINUOUS-WAVE OPERATION OF APERTURED, INTRACAVITY CONTACTED, 1.55 MUM VERTICAL-CAVITY SURFACE-EMITTING LASERS" APPLIED PHYSICS LETTERS, AMERICAN INSTITUTE OF PHYSICS. NEW YORK, US, vol. 78, no. 10, 5 March 2001 (2001-03-05), pages 1337-1339, XP001012107 ISSN: 0003-6951
- SYRBU A V ET AL: "Room-Temperature Pulsed Operation of 1.52 /spl mu/m Vertical Cavity Lasers Obtained by Localised Fusion" PROCEEDINGS OF THE 1998 INTERNATIONAL SYMPOSIUM ON INFORMATION THEORY, CLEO/EUROPE'98; GLASGOW, SCOTLAND, XP010306639
- ORTSIEFER M ET AL: "Room-temperature operation of index-guided 1.55 µm InP-based vertical-cavity surface-emitting laser" ELECTRONICS LETTERS, IEE STEVENAGE, GB, vol. 36, no. 5, 2 March 2000 (2000-03-02), pages 437-439, XP006014948 ISSN: 0013-5194 cited in the application
- BOUCART J ET AL: "METAMORPHIC DBR AND TUNNEL-JUNCTION INJECTION: A CW RT MONOLITHIC LONG-WAVELENGTH VCSEL" IEEE JOURNAL OF SELECTED TOPICS IN QUANTUM ELECTRONICS, IEEE SERVICE CENTER, US, vol. 5, no. 3, May 1999 (1999-05), pages 520-528, XP000930532 ISSN: 1077-260X cited in the application

## Description

### FIELD OF THE INVENTION

This invention relates to vertical cavity surface emitting lasers (VCSELs), and particularly to electrically pumped, long wavelength VCSELs and multiple wavelength VCSEL arrays, and a method of fabrication thereof.

### BACKGROUND OF THE INVENTION

A VCSEL is a semiconductor laser including an active region sandwiched between mirror stacks that can be semiconductor distributed Bragg reflectors (DBRs) [N.M. Margalit et al., "Laterally Oxidized Long Wavelength CW Vertical cavity Lasers", Appl. Phys. Lett., 69 (4), July 22 1996, pp. 471-472], or a combination of semiconductor and dielectric DBRs [Y. Oshio et al., "1.55µm Vertical-Cavity Surface-Emitting Lasers with Wafer-Fused InGaAsP/InP-GaAs/AlAs DBRs", Electronics Letters, Vol. 32, No. 16, 1st August 1996]. One of the mirror stacks is typically partially reflective so as to pass a portion of the coherent light that builds up in a resonating cavity formed by the mirror stacks sandwiching the active region. The VCSEL is driven by a current forced through the active region. Mirror stacks are typically formed of multiple pairs of layers formed of a material system generally consisting of two materials having different indices of refraction and being easily lattice matched to the other portions of the VCSEL. For example, a GaAs based VCSEL typically uses an AlAs/GaAs or AlGaAs/AlAs material system wherein the different refractive index of each layer of a pair is achieved by altering the aluminum content in the layers.

VCSELs are well adapted as preferred light sources for communication applications, due to the following advantageous features: a single mode signal from a VCSEL is easily coupled into an optical fiber, has low divergence, and is inherently single frequency in operation.

One of important requirements for the operation of a VCSEL is to compensate for the small amount of gain media which is typical for VCSELs due to the compact nature thereof. This is associated with the fact that, in order to reach the threshold for lasing, the total gain of a VCSEL must be equal to the total optical loss of the VCSEL. To compensate for the small amount of gain media, and to enable reaching and maintaining the lasing threshold, it is known to use wafer fusion of one or both of the mirror stacks, with reflectivity values exceeding 99.5%, to the active region. Wafer fusion is a process by which materials of different lattice constant are atomically joined by applying pressure and heat to create a real physical bond.

VCSELs emitting light having a long wavelength are of great interest in the optical telecommunication industry. A long wavelength VCSEL can be obtained by using a VCSEL having an InGaAs/InGaAsP active cavity material, in which case an InP/InGaAsP material system must be used for the mirror stacks in order to achieve a lattice match to the InP. In this system, however, it is practically impossible to achieve DBR based mirrors with high enough reflectivity because of the small difference in the refractive indices in this material system. Many attempts have been made to address this problem including a wafer fusion technique in which a DBR mirror is grown on a separate substrate and fused to the active region.

Another important requirement for fundamental mode operation of a VCSEL and light coupling into a single mode fiber, is current and optical confinement. In order to reduce the light emitting area of the VCSEL (practically to about 5-10 µm), the opening of current flow (current aperture) is restricted through lateral oxidation of Al-containing layers which also creates a lateral refractive index variation for fundamental optical mode operation of these devices. In such a lateral oxidation technique, a mesa is etched into the top surface of the VCSEL wafer, and the exposed sidewalls of an Al-containing layer (typically AlGaAs layer) are exposed to water vapor at elevated temperature. Water vapor exposure causes conversion of the AlGaAs to AlGaOₓ, some distance in from the sidewall toward the central vertical axis depending on the duration of oxidation. Formation of the current aperture defines the active region of the device which includes the active cavity material where there is a current flow and the light is generated, while lateral refractive index variation allows to control the mode structure of the emitted light. This approach has been used for practically all short-wavelength AlGaAs/Ga(In)As(P) VCSELs (i.e., emitting at 0.65-1.1µm) and is also applied to long wavelength VCSELs (i.e., emitting at 1.25-1.65 µm) that may comprise DBR mirrors grown in the same material system as the active region [S. Rapp et al., "Near-Room-Temperature Continuous-Wave Operation of Electrically Pumped 1.55µm Vertical cavity Lasers with InGaAsP/InP Bottom Mirror", Electronic Letters, Vol. 35, No. 1, 7^{th} January 1999], and AlGaAs based DBRs that are as-grown [W. Yuen et al., "High Performance 1.6µm Single-Epitaxy Top-Emitting VCSEL, Electronic Letters, Vol. 36, No. 13, 22^{nd} June 2000] or wafer-fused on the active cavity material grown on InP (as in the above-indicated article of N.M. Margalit et al.). However, this approach leads to a non-planar structure, since mesa etches are required, resulting in a complicated processing scheme and low yield. The lateral oxidation is very sensitive to various factors like temperature, surface quality and defects, and does not allow obtaining current apertures with a precise size, and, above all, uniform enough to be used in the fabrication of multiple wavelength arrays by cavity length engineering. In case of lateral oxidized devices, it is quite difficult to use high performance AlAs/GaAs DBRs with highest refractive index contrast and best thermal characteristics, as compared to other AlGaAs/GaAs DBRs.

The use of the wafer fusion technique allows for obtaining both current and optical confinement during the fusion of the p-type GaAs-based DBRs to the p-side of the active cavity material grown on InP wafers. To this end, a special structuring of one of two contacting wafers is performed. The structured surface consists of a central mesa surrounded by shallow etched regions and a large area of unetched semiconductor. The fusion front in the central mesa and the large area of the unetched semiconductor are in the same plane. The current confinement is obtained by placing a native oxide layer at the fused interface outside the central mesa [A.V. Syrbu, V.P. Iakovlev, C.A. Berseth, O. Dahaese, A. Rudra, E. Kapon, J.Jacquet, J. Boucart, C. Stark, F. Gaborit, I. Sagnes, J.C. Harmand and R. Raj, "30° CW Operation of 1.52µm InGaAsP/AlGaAs Vertical Cavity Lasers with in situ built-in lateral current confinement by localized fusion", Electronic Letters, Vol. 34, No. 18, 3^{rd} September 1998; or by placing a proton implanted region at the fused interface outside the central mesa (US Patent No. 5,985,686). This approach, however, suffers from the following drawbacks: the fused p-GaAs-based and p-InP-based interfaces are normally highly resistive resulting in a substantial heating of the device; and it is very difficult to optimize p-AlGaAs/GaAs DBRs for long wavelength VCSELs to have both high reflectivity (low absorption) and low resistivity.

According to a different approach of the long wavelength VCSEL fabrication technique, tunnel junctions can be used to inject holes into the active region, allowing using n-type DBRs on both sides of the active cavity material. In US Patent WO 98/07218, the p-side of a InP-based active cavity material is fused to the p-GaAs side of an AlGaAs/GaAs based structure including the n-type DBR stack and the n⁺⁺/p⁺⁺ tunnel junction. Standard mesa etching and AlGaAs wet oxidation are performed for lateral optical and current confinement in these devices. Besides the above-mentioned drawbacks related to this particular lateral confinement technique and to highly resistive p-GaAs/p-InP fused junctions, this approach suffers from the known difficulty in obtaining low resistive reversed biased tunnel junctions in GaAs, as compared to lower band-gap materials.

In a more recent approach, the so-called "buried tunnel junction structure" formed in the low band-gap InP-based active cavity material is used. [M. Ortsiefer et al., "Room-Temperature Operation of Index-Guided 1.55µm In-P-based Vertical cavity Surface-Emitting Laser", Electronic Letters, Vol. 36, No. 13, 2^{nd} March 2000]. This VCSEL structure comprises one oxide DBR and one semiconductor DBR. The n-type semiconductor DBR, the cavity material terminating with a p-type material, and the p⁺⁺/n⁺⁺ tunnel junction structure are grown in the first epitaxial process. Then, a shallow mesa structure is etched through the tunnel junction until reaching the p⁺⁺ region and regrown with a n-type InP layer in the second epitaxial process. This is followed by the deposition of an oxide DBR on the n-InP. In this structure, the buried tunnel junction provides a means for lateral current confinement. However, an oxide DBR with intrinsically low thermal conductivity is placed between the active region and the heat-sink. The final device represents a free standing epitaxial structure without a substrate, thereby adding complexity in handling and processing such devices and reducing the yield.

The article "Metamorphic DBR and Tunnel-Junction Injection: A CW RT Monolithic Long-Wavelength VCSEL", J. Boucart et al., IEEE Journal of Selected Topics in Quantum Electronics, Vol. 5, No. 3, 1999, pp. 520-529 discloses a VCSEL comprising a tunnel junction incorporated into the active cavity material and a metamorphic n-type AlGaAs/GaAs DBR grown over the active cavity material in the same epitaxial process. In this case, the heat dissipation is improved due to the good thermal conductivity of the n-AlGaAs DBR. The lateral current confinement is obtained as a result of deep proton implantation through the top AlGaAs/GaAs DBR and tunnel junction. However, such a structure is characterized by the lattice mismatch of 3.7% between GaAs-based and InP-based compounds, resulting in a high density of defects in the metamorphic AlGaAs/GaAs DBR. These defects propagate into the active region which may result in a fast degradation of the device. The proton implantation also creates defects and especially in the InP-based active cavity material. Additionally, the resulting structure does not comprise a means for lateral optical confinement.

New generations of local area networks will use the wavelength division multiplexing (WDM) concept in order to achieve broad band transmission. Multiple wavelength VCSEL arrays may play an important role in these systems. The article "WDM Array Using Long-Wavelength Vertical Cavity Lasers" V. Jayaraman and M. Kilcoyne in Proc. SPIE: Wavelength Division Multiplexing Components, vol. 2690, 1996, pp. 325-336, discloses optically pumped VCSEL arrays emitting at 1550nm in which cavity length of different VCSELs in array is changed by selective etching of an InGaAsP/InP superlattice which is included in the VCSEL cavity. The disadvantage of this device structure is that it also does not include a means for lateral optical confinement..

### SUMMARY OF THE INVENTION

There is accordingly a need in the art to improve the operation of long wavelength VCSELs by providing a novel VCSEL device structure, and a method of its fabrication.

The main idea of the present invention consists of the following. A VCSEL device structure that includes an active cavity material sandwiched between two DBRs is formed with an active region defined by an aperture between a structured surface of the active cavity material and a substantially planar surface of a *n*-type layer of one of the DBRs, the structured surface and the planar surface of the n-type layer being fused to each other. The structured surface is formed by a top surface of a mesa, which includes at least an upper n⁺⁺ layer of a p⁺⁺/n⁺⁺ tunnel junction formed on top of a *p*-semiconductor layer which is part of the active cavity material, and a top surface of a p-type layer (i.e., either the p⁺⁺ layer of the tunnel junction, or the p-semiconductor layer, as the case may be) outside the mesa. The structured surface (i.e., both the upper surface of the mesa and the surface of the *p*-type layer outside the mesa) is fused to the planar surface of the *n*-type layer of the DBR, as a result of deformation of these surfaces. As a consequence, an air gap is formed in the vicinity of the mesa between the fused surfaces, presenting the aperture between the fused surfaces. This allows for restricting an electrical current flow to the active cavity material (i.e., the formation of the current aperture which defines the active region), and for lateral variation of the index of refraction within the active region.

Thus, the aperture defining the active region includes the mesa (at least the upper n⁺⁺ layer of the tunnel junction) clamped by the wafer fusion between the structured surface of the active cavity material and the substantially planar surface of the n-type layer of the DBR stack. The air gap existing between the fused surfaces provides a lateral refractive index variation in the proposed device structure.

The term ***"p-type layer outside a mesa"*** used herein signifies a layer of the active cavity material, which is either a p-layer underneath a p⁺⁺/n⁺⁺ tunnel junction structure or the lower p⁺⁺ layer of the tunnel junction. The term ***"fusion"*** signifies a wafer fusion technique consisting of atomically joining two surfaces by applying pressure and heat to create a real physical bond between the fused surfaces.

Thus, according to the technique of the present invention, a mesa is formed in the tunnel junction (a stack of p⁺⁺ and n⁺⁺ layers) on top of a p-layer which is part of the active cavity material, and the wafer fusion is applied between a lower n-type planar layer of the DBR and the structured surface of the active cavity material. This process, due to deformation of the wafers (DBR structure and the active cavity material structure), results in a specific topology of the layers around the mesa and in the creation of an air gap defined by the height of the mesa and the pressure applied at fusion temperature. The provision of the air gap allows for the lateral refractive index variation in the active region of the device. The provision of an electric field directed from top to bottom causes both the tunnel junction in the mesa and the n-p (or n-p⁺⁺) fused interface to be reversed biased, thereby restricting the current flow through the mesa.

The VCSEL device according to the invention is fabricated in the following manner:

An active cavity material terminating with a p⁺⁺/n⁺⁺ tunnel junction is grown on a InP substrate. The active cavity material incorporates a bottom n-type spacer, a multi-quantum well structure, and a top spacer terminating with a p-layer on which the tunnel junction is grown. Then, a mesa-structure is etched through the tunnel junction up to either the p-layer or p⁺⁺-layer (generally, the p-type layer), thereby obtaining a structured surface of the active cavity material terminating with the n⁺⁺-layer on the top of the mesa and the p-type layer outside the mesa. Thereafter, the fusion of an n-type AlAs/GaAs DBR to the structured surface of the active cavity material is carried out by contacting these wafers face to face and applying a pressure at elevated temperature. By this, due to deformation of the wafers, a high quality fusion of both the n⁺⁺ material on the top of the mesa and the p (or p⁺⁺) material outside the mesa to the n-type AlAs/GaAs DBR is obtained. The InP substrate is then selectively etched, and a bottom n-type AlAs/GaAs DBR is fused to the n-side of the active cavity material structure. The GaAs substrate of the top DBR is selectively etched, and ohmic contacts are deposited onto both sides of the device.

When a bias voltage is appropriately applied to the contacts of the device so that the corresponding electrical field is directed from top to bottom (direct voltage), both the tunnel junction in the mesa and the n-p (or n-p⁺⁺) fused interface are reverse-biased. The reverse-biased tunnel junctions are well conducting and the reverse-biased n-p (or n-p⁺⁺) fused interface is not conducting. Therefore, the restriction of the current flow through the mesa (i.e., the formation of the current aperture) is obtained. The part of the active cavity material where the current flows after passing through the current aperture is the active region of the device where the light is generated. Electrical localization can be further improved by forming an additional electrical confining layer, such as a proton implantation layer on the active cavity material structure around the mesa, prior to performing fusion to the n-DBR.

Thus, according to one aspect of the present invention, there is provided a vertical cavity surface emitting laser (VCSEL) device structure, which comprises a semiconductor active cavity material sandwiched between top and bottom distributed Bragg reflector (DBR) stacks, the top DBR stack including at least one n-type semiconductor layer, and which defines an active region for generating light in response to the application of a direct voltage to device contacts, wherein:
- said active cavity material comprises a multiquantum well stack sandwiched between bottom and top spacer regions, the top spacer region terminating with a p-layer and a p⁺⁺/n⁺⁺ tunnel junction on top of said *p*-layer, each of the p⁺⁺ and p-layer presenting a p-type layer, at least the upper n⁺⁺ layer of the tunnel junction being a mesa emerging from the underlying p-type layer, a structured surface of the active cavity material being formed by an upper surface of the mesa and an upper surface of the p-type layer outside the mesa;
- said active region is defined by a current aperture including the mesa surrounded by an air gap between the fused structured surface of the active cavity material and the surface of the n-type semiconductor layer of the DBR stack.

The VCSEL device structure according to the invention may comprise at least one additional active region sandwiched between the same top and bottom DBRs, the active regions being fabricated starting from the same active cavity material. The different active regions have separate contacts and electrical isolation, thereby allowing to perform separate electrical pumping of every active region. The different active regions may be designed to have different cavity lengths so that light emitted through the DBRs will be of different wavelengths. To this end, the mesas defining different active regions can be fabricated of different heights, and consequently different active regions will have different cavity lengths. This is implemented by making said at least one additional mesa terminating with an additional n-type layer on top of the n⁺⁺ layer of the tunnel junction. Preferably, this additional n-type layer has a thickness not exceeding 1/8 of the emission wavelength inside the VCSEL structure, and is composed of a certain number of pairs of layers, the layers of each pair being of different chemical composition. If n such additional mesas (active regions) are provided, each of the additional mesas contains a portion of the additional n-type layer of a thickness different to that of the other additional mesas. In order to provide an equal minimal wavelength separation between the light emitted through the DBRs sandwiching different active regions, the difference between the thickness values of the active cavity material including the additional n-type layer in corresponding active regions is made equal.

According to another aspect of the present invention, there is provided a method of fabrication of a vertical cavity surface emitting laser (VCSEL) device structure, the method comprising the steps of:
(i) growing a semiconductor active cavity material consisting of a multiquantum well layer stack sandwiched between bottom and top spacer regions, the top spacer region terminating with a p-layer and a p⁺⁺/n⁺⁺ tunnel junction grown on top of the p-layer, each of the p⁺⁺-and p-layer presenting a p-type layer;
(ii) etching the active cavity material formed in step (i) to form a mesa including at least the upper n⁺⁺ layer of the tunnel junction emerging from the underlying p-type layer, thereby creating a structured surface of the active cavity material formed by the upper surface of the mesa and the upper surface of the p-type layer outside the mesa;
(iii) applying a wafer fusion between the structured surface of the active cavity material and a substantially planar surface of a n-type semiconductor layer of a first distributed Bragg reflector (DBR) stack, thereby causing deformation of the fused surface around the - mesa and defining an aperture region for electrical current flow therethrough, the aperture region including the mesa surrounded by an air gap between the deformed fused surfaces and defining an active region of the device;
(iv) forming a second DBR stack on the surface of the active cavity material opposite to the structured surface;
(v) forming ohmic contacts on the VCSEL device structure to enable the electrical current flow through the current aperture to the active region.

To form the VCSEL device structure containing at least one additional active region starting from the same active cavity material, an additional n-type layer is provided on top of the n⁺⁺-layer of the tunnel junction, prior to performing step (ii). In this case, during step (ii), at least one additional mesa is formed containing also a portion of this additional n-type layer.

Distinguished from the known techniques of fabricating long wavelength VCSELs based on the tunnel junction approach, the technique of the present invention allows using a high structural quality AlAs/GaAs DBR with very good thermal conductivity. Both lateral electrical and optical confinements are obtained while performing the fusion of the AlAs/GaAs DBR to the active cavity material with a low resistivity n⁺⁺InP-based/n-GaAs fused junction.

It should be noted that the method of fabrication of the device according to the invention is simple, does not include any non-standard process, and allows the fabrication of multiple wavelength VCSEL arrays. The final device is mechanically stable allowing a large scale and low cost production.

### BRIEF DESCRIPTION OF THE DRAWINGS

In order to understand the invention and to see how it may be carried out in practice, several embodiments will now be described, by way of non-limiting examples only, with reference to the accompanying drawings, in which:
**Fig. 1A** illustrates a layer structure of a VCSEL device according to one embodiment of the invention;
**Fig. 1B** illustrates the refractive index variation and standing optical wave within an active cavity material and adjacent DBRs of the device of Fig. 1A, and
**Figs. 2 to 4** illustrate the fabrication of the VCSEL device of Fig. 1A;
**Fig. 5** is a schematic representation of a VCSEL device according to another embodiment of the invention;
**Fig. 6** illustrates the fabrication of the VCSEL device of Fig. 5;
**Fig. 7** is a schematic representation of a VCSEL device according to yet another embodiment of the invention;
**Fig. 8** is a schematic representation of an electrically pumped multiple wavelength VCSEL array according to the present invention; and
**Figs. 9 and 10** illustrate the fabrication of the device of Fig. 8.

### DETAILED DESCRIPTION OF THE INVENTION

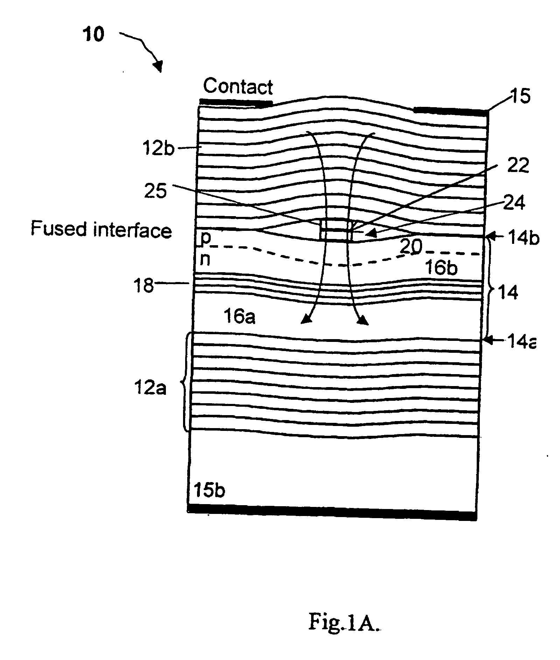

Fig. 1A illustrates a VCSEL device structure, generally designated **10,** according to one embodiment of the present invention. The device **10** is composed of bottom and top n-AlAs/GaAs DBRs **12a** and **12b,** and an active cavity material, generally at **14,** therebetween. The DBRs **12a** and **12b** are bonded to, respectively, a bottom surface **14a** and an upper, structured surface **14b** of the active cavity material **14,** by wafer fusion. Ohmic contacts, generally at **15,** are provided on opposite sides of the device **10.**

The active cavity material **14** is a structure incorporating a bottom n-type spacer **16a,** a multi-quantum well (MQW) structure **18,** a top spacer **16b** terminating with a p-type layer **20,** and a mesa **22,** which is p⁺⁺/n⁺⁺ tunnel junction composed of a p⁺⁺ bottom layer and a top n⁺⁺ layer. Hence, the structured surface **14b** is formed by the upper surfaces of the mesa **22** and of the p-type layer **20** outside the mesa **22.** The lower surface of the n-type DBR **12b** (i.e., of the n-semiconductor layer of the mirror structure) at one side and the structured surface **14b** at the other side form a fused interface. The mesa **22** is clamped between the fused surfaces due to deformation thereof, an elongated air gap **24** being created in the vicinity of the mesa **22**. The mesa within the air gap between the fused deformed surfaces presents an aperture region **25** for an electrical current flow therethrough, while the air gap provides lateral refractive index variation for optical mode confinement. The current aperture **25** defines an active region as a part of the active cavity material **14** where the current flows after passing through the current aperture **25** and where light is generated.

The application of a bias voltage to the contacts **15** results in an electrical field directed from top to bottom, such that the tunnel junction in the mesa **22** and the n-p fused interface are reversed biased, being, respectively, well conducting and not conducting. The restriction of the current flow through the mesa is thereby obtained.

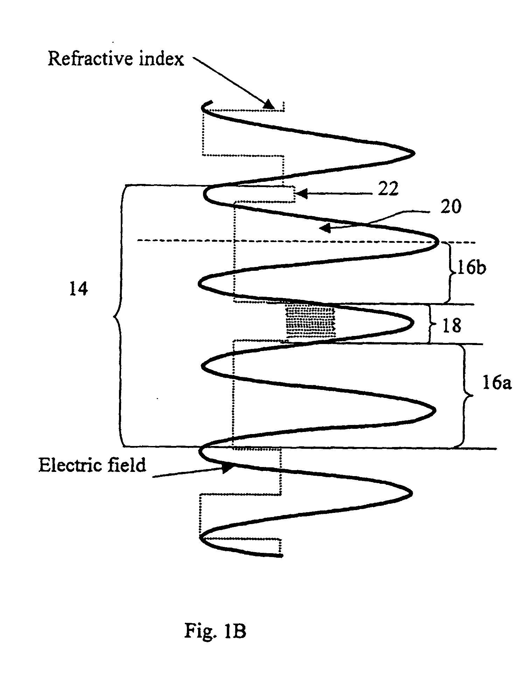

Fig. 1B shows refractive index variation within the active cavity material and adjacent DBRs of the VCSEL device structure **10,** and the standing wave (electric field) profile at the emission wavelength. As shown, that the region of the multi-quantum well structure **18** is situated in a maximum of electric field, while the tunnel junction **TJ** is situated in a minimum of the standing wave, thus not introducing absorption of the light emitted by the VCSEL device structure **10**.

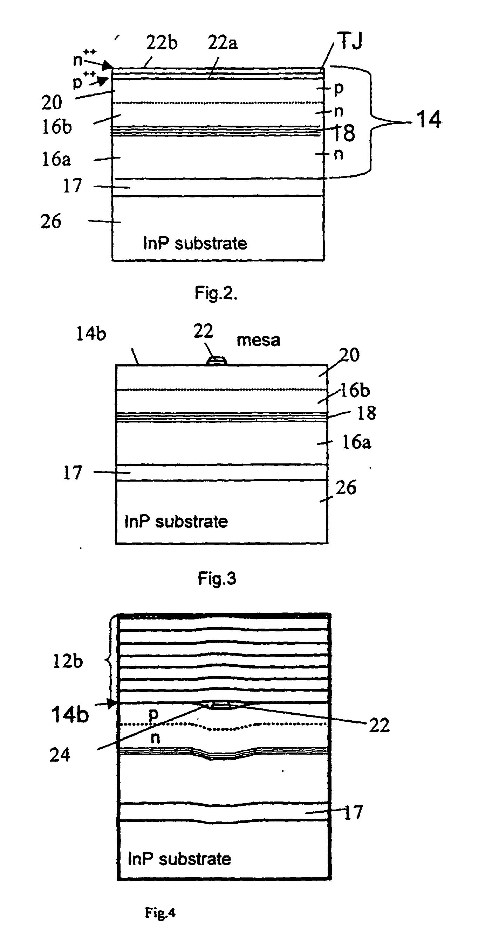

The main steps in the fabrication of the device **10** will now be described with reference to Figs. 2-4:

In the first step (Fig. 2), the active cavity material **14** (wafer structure) is fabricated by sequentially growing on a n-type InP substrate **26,** an InGaAsP-etch-stop layer **17,** the bottom n-InP spacer layer **16a,** the undoped MQW structure **18,** the top InP spacer layer **16b** terminating with the p-type InP layer **20,** and the p⁺⁺/n⁺⁺ tunnel junction **TJ.**

In the present example, the following layers' parameters are used. The InGaAsP-etch-stop layer **17** has the maximum of photoluminescence (PLₘₐₓ) at 1.4µm (i.e., PLₘₐₓ=1.4µm) and a thickness of 113nm. The bottom n-InP spacer layer **16a** has a doping level, *n*, of 3.10¹⁷ cm⁻³ and a thickness of 305nm. The undoped MQW structure **18** comprises 6 quantum wells of InGaAsP with PLₘₐₓ= 1.54 µm and thickness of 8nm, and 7 barriers of InGaAsP with PLₘₐₓ= 1.38µm and thickness of 9.4nm. The top InP spacer layer **16b** comprises 101nm of undoped InP. The p-type InP layer **20** has a thickness of 192nm and a doping level p=5.10¹⁷cm⁻³. The p⁺⁺/n⁺⁺ tunnel junction **TJ** is formed by the p⁺⁺-InGaAs layer **22a** with a doping level p=5.10¹⁹ cm⁻³ and thickness of 15nm, and the n⁺⁺-InGaAs layer **22b** with a doping level n=5.10¹⁹ cm⁻³ and thickness of 15nm, the tunnel junction **TJ** thus having the total thickness of 30nm. Generally, the thickness of the tunnel junction ranges between 20 and 50nm.

In the second step (Fig. 3), the mesa-structure **22** is etched through the tunnel junction **TJ** using a selective etching in a H₃PO₄:H₂O₂: H₂O based solution, thereby obtaining the structured surface **14b** of the active cavity material structure **14**. In the present example, the etching is performed using a 10µm diameter photoresist mask and is continued until the p-type layer **20** is reached, the surface of the layer **20** thereby presenting the p-type layer outside the mesa to be fused to the n-type DBR **12b.** It should, however, be noted that the etching could continue until the p⁺⁺ layer **22a** of the tunnel junction is reached, in which case the surface of layer **22a** will present p-type layer outside the mesa to be fused.

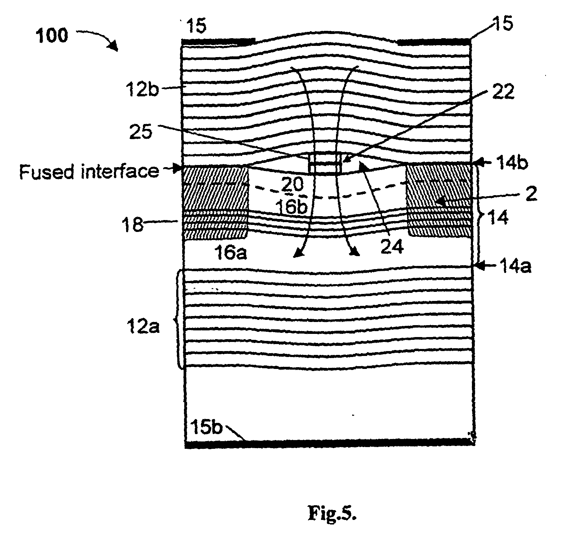

In the third step (Fig. 4), the n-type DBR stack **12b** and the active cavity material **14** are brought into face-to-face contact, and a pressure at elevated temperature is applied, thereby performing the fusion of the surface of the lower n-semiconductor layer of the DBR **12b** to the structured surface **14b.** The DBR stack **12b** is a AlAs/GaAs DBR structure grown by Metalo-Organic Chemical Vapor Deposition (MOCVD) on a GaAs-substrate, and comprises 25 pairs of AlAs with the doping level n=10¹⁸ cm⁻³ and thickness of 130nm, and GaAs with the doping level n=10¹⁸ cm⁻³ and thickness of 114nm.

The fusion set-up, which is basically a pneumatic press, allows changing the pressure applied to the wafers that are in contact at different stages of the fusion process. In order to avoid defects formation in the active region, it is very important that, during purging at room temperature, the pressure applied to the wafers does not exceed 0.5 bar. This low pressure is kept during the heating cycle till reaching the fusion temperature of 650°C. Then, the pressure is gradually increased up to 2.0 bar, and the wafers are kept in these conditions for 30 minutes. During the fusion process, the wafers are deformed, and a high quality fusion of both the n⁺⁺ material on the top of the mesa **22** and the p-type material outside the mesa to the n-type AlAs/GaAs DBR **12b** is obtained, and the air gap **24** is formed.

In the last step, the InP substrate is selectively etched in HCl till reaching the InGaAsP etch stop layer **17** which is also selectively etched in a H₃PO₄:H₂O₂:H₂O solution. Then the bottom n-type AlAs/GaAs DBR **12a** is fused to the n-side of the active cavity material. In the present example, the DBR **12a** comprises 27 pairs of AlAs and GaAs layers with the same thickness and doping level values as those of the layers in the top DBR stack **12b.** The GaAs substrate of the top DBR is selectively etched in a H₂O₂-NH₃OH solution till reaching the first AlAs layer which acts as an etch-stop and which is also selectively etched in HF, and Ni-Au-Ge-Au ohmic contacts **15** are deposited onto both sides of the device. The VCSEL device structure **10** obtained according to this process emits at 1520nm.

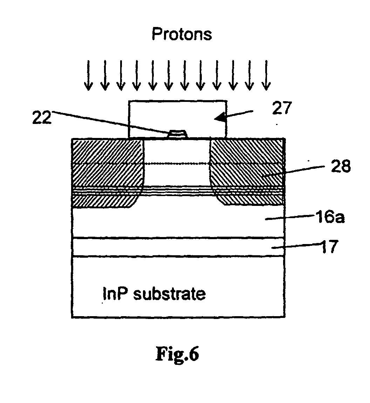

Referring to Figs. 5 and 6, there is illustrated a VCSEL device structure 100 according to another embodiment of the present invention. To facilitate understanding, the same reference numbers are used for identifying those components that are identical in the devices **10** and **100**. The device **100** is fabricated using a proton implantation through the active cavity material **14** outside the mesa **22** prior to performing the fusion of the top DBR **12b,** thereby allowing to further improve electrical localization through the aperture region **25** of the VCSEL device structure **100.**

To manufacture the device **100**, the structured active cavity material preparation is carried out as described above with respect to the fabrication of the device **10**, and thereafter, as shown in Fig. 6, a photoresist disc **27** are formed over the mesa **22** in such a way that this disc is concentric with the mesa. The disc **27** serves as a mask having a diameter of 30µm and a thickness of 2µm. Masking of the mesa is followed by a proton implantation of the surface of the active cavity material **14** with a doze of 5.10¹⁴ at an energy of 80keV. The implantation energy and dose are selected in such a way that an implantation layer **28** (Fig. 5) reaches the bottom n-InP spacer **16a.**

After the proton implantation, the photoresist mask **27** is removed in acetone and oxygen plasma, and the following steps are similar to those described above with respect to the fabrication of the device 10. As a result, the VCSEL device **100** is obtained having an additional proton implantation current confining layer **28,** which only reaches the outer boundary of the air-gap **24** surrounding the mesa **22,** and does not introduce defects in the active region defined by aperture **25** because it is situated outside the active region and quite away therefrom. Implantation of oxygen or other ions can be also used for this purpose.

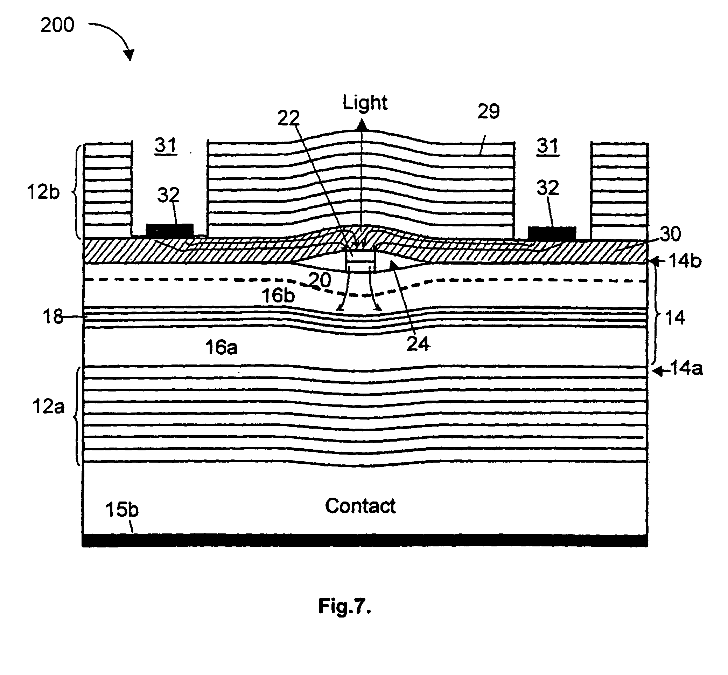

Fig. 7 schematically illustrates a VCSEL device structure **200** according to yet another embodiment of the invention. Similarly, the same reference numbers are used for identifying the components which are common with the previously described examples. In the present example of Fig. 7, a top DBR **12b** is a AlAs/GaAs stack, in which only a top GaAs layer **30** is n-type doped with a carrier concentration of 5.10¹⁸ cm⁻³, and all other layers are undoped. The DBR stack **12b** is brought into contact with the active cavity material **14** and the top *n*-GaAs layer **30** of the DBR stack **12b** is fused to the structured surface **14b** of the active cavity material **14** in the above-described manner. Thereafter, the GaAs-substrate of the top DBR **12b** is selectively etched in a H₂O₂-NH₃OH solution. Reactive plasma dry etching in Cl₂-CH₋₄-Ar is used to form an annular recess **31** in the top DBR stack **12b** till reaching the n-type GaAs layer **30,** and to thereby define a central stack region **29** of the top DBR **12b** surrounded by this annular recess **31.** This process is followed by depositing top ohmic contacts **32** inside the recess **31.**

When a direct voltage is applied between the top contacts 32 and a bottom contact **15b**, an electrical current passes along the n-type layer **30** towards the aperture region **25** and, then, through the active region. The advantage of using the top DBR **12b** with all the layers, except for the top layer **30**, being undoped is in reduced light absorption in the DBR through which light is extracted from the device, thereby allowing increasing the VCSEL emission power.

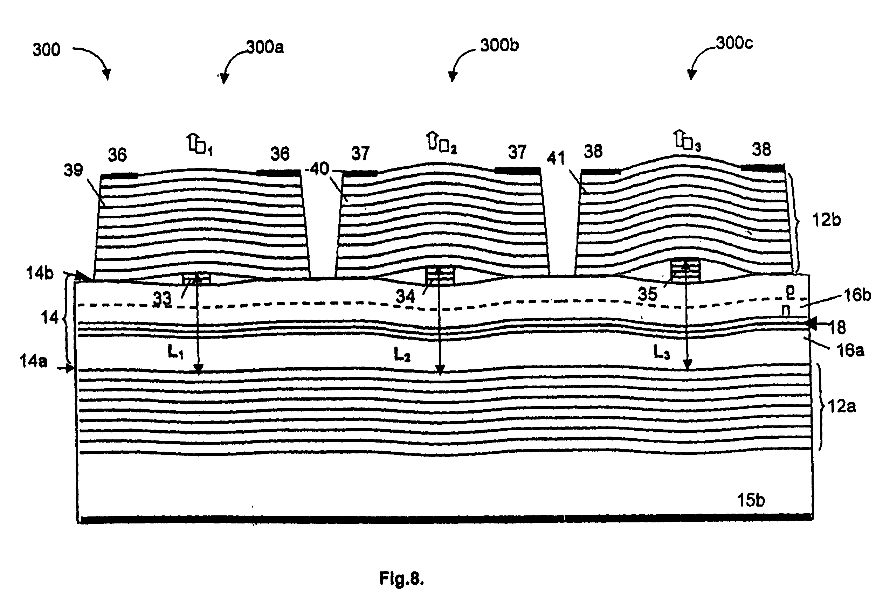

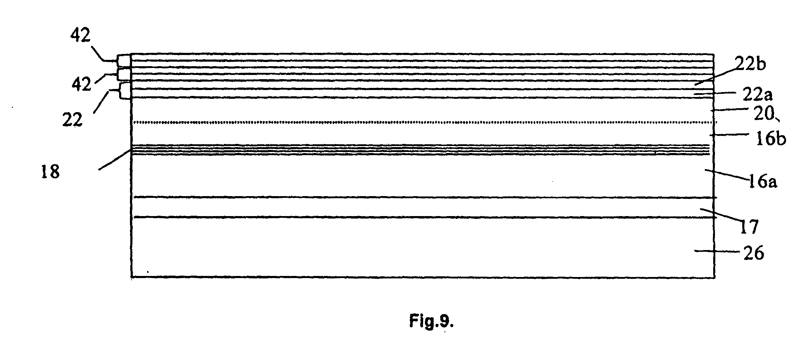

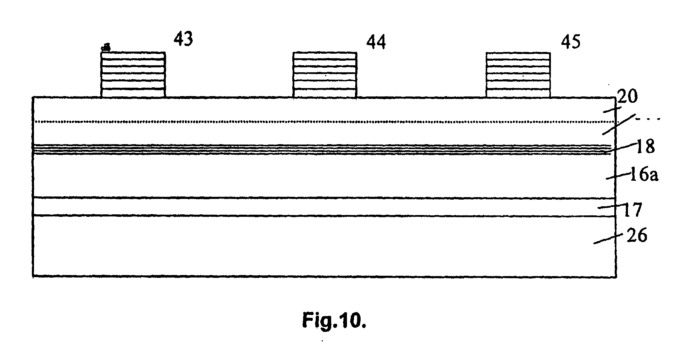

Turning now to Figs. 8-10, there is illustrated a further embodiment of the present invention. Fig. 8 schematically shows a VCSEL device structure **300** in the form of a multiple wavelength VCSEL array, which, in the present example, comprises an array of three - VCSEL devices **300a, 300b** and **300c** emitting different wavelengths λ₁, λ₂ and λ₃, respectively. Figs. 9 and 10 illustrate the fabrication of the device structure **300.**

The emission of different wavelengths is obtained by providing different lengths **L**_{**1**}**, L**_{**2**}**, L**_{**3**} of structured active cavity material within the adjacent devices **300a, 300b** and **300c,** respectively, due to different heights of mesas **33, 34** and **35.** Annular ohmic contacts **36, 37** and **38** are formed on the top n-type DBR **12b,** after selective etching of the top GaAs substrate. Then, isolation mesa-structures **39, 40** and **41** are formed in the top DBR **12b** by reactive plasma etching in Cl₂-CH₋₄-Ar. Each of the annular contacts **36, 37, 38** and the corresponding one of the isolation mesa-structures **39, 40, 41** are centered with respect to a vertical axis passing through the center of the corresponding one of the mesas **33, 34, 35,** respectively. By applying a direct voltage between one of the top contacts **36, 37** or **38** and a bottom contact **15b,** a current flow through the active region of the respective VCSEL device (**330a, 330b** or **300c**) is provided, and light is emitted at the respective wavelength depending on the cavity length of this particular device.

For telecommunication applications, it is important to precisely control emission wavelengths of lasers in multiple wavelength VCSEL arrays in such a way that an equal wavelength separation Δλ between the VCSELs in the array is obtained. This can be performed by ensuring an equal cavity length separation ΔL of neighboring devices. In this embodiment of the invention, as shown in Fig. 9, layers **22a** and **22b** of the tunnel junction are grown on the InP based cavity material, and then two pairs **42** of InP-InGaAsP layers are grown. Each layer in the pair-layers InP-InGaAsP has a thickness of 10nm and a n-type doping level of 5·10¹⁷ cm⁻³. The composition of InGaAsP layers corresponds to PLₘₐₓ of 1.4µm. Generally, this additional n-type layer is composed of a desired number of pairs Np of layers, every pair having two layers of different chemical composition. The relation between the desired number of separate wavelengths N and Nₚ is Nₚ=N-1.

The above process of the layers formation is followed by selectively etching the layers **42** and the tunnel junction layers **22a** and **22b** in a H₃PO₄:H₂O₂: H₂O based solution and HCl till reaching the p-type layer **20** of the InP-based cavity material to form mesas **43, 44** and **45** (Fig. 10). Each of the mesas **43, 44** and **45** has a diameter of 10µm.

Turning back to Fig. 8, the above process of selective etching is followed by a precise mesa trimming using photolithography and selective etching in a H₃PO₄:H₂O₂: H₂O based solution and HCl, resulting in the formation of mesas **33,** **34** and **35** of different heights. Mesa **35** is composed of the tunnel junction layers **22a** and **22b,** and two pairs of layers **42** with a total height of 70nm. Mesa **34** is composed of the tunnel junction layers **22a** and **22b,** and the pair of layers **42** with a total height of 50nm. Mesa **33** is composed only of the tunnel junction layers **22a** and **22b,** and has a height of 30nm. The difference between the optical cavity length of each two neighboring VCSEL devices in the array (**300a** and **300b, 300b** and **330c**) is the same (20nm multiplied by the effective refractive index of the InP-InGaAsP pair layers) allowing obtaining an equal difference Δλ between emission wavelength of the neighboring VCSELs. In this particular example, the emission wavelength values of the devices with mesas **33, 34** and **35** have been measured to be 1520nm, 1538nm and 1556nm, respectively, resulting in the Δλ of 18nm.

Generally, in order to provide mesas of different heights, some mesas terminate with an additional n-type layer on top of the n⁺⁺ layer **22b** of the tunnel junction. The additional n-type layer is composed of a certain number of pairs of layers, every pair having two layers of different chemical compositions. A portion of the additional n-type layer in the respective mesa has a thickness different from that of the other mesas. Considering *d* as the thickness of this additional n-type layer as being deposited and prior to being etched to form *N* different mesas, after the selective etching of this layer, the thickness *d*_{*i*} of the remaining portion thereof in i^{th} mesa (i=1, 2, ..., N) is dᵢ'≅(i-1)d/(N-1). This thickness *d*_{*i*} does not exceed 1/8 of the emission wavelength inside the respective VCSEL device, i.e. about 60nm.

Those skilled in the art will readily appreciate that various modifications and changes can be applied to the preferred embodiment of the invention as hereinbefore exemplified without departing from its scope defined in and by the appended claims.

## Claims

1. A vertical cavity surface emitting laser (VCSEL) device structure (10), which comprises a semiconductor active cavity material structure (14) sandwiched between top and bottom Distributed Bragg Reflector (DBR) stacks (12a, 12b), the top DBR (12b) including at least one n-type semiconductor layer, and which defines an active region for generating light in response to application of a direct voltage to device contacts (15), wherein:
- said active cavity material comprises a multiquantum well layer stack (18) sandwiched between bottom and top spacer regions (16a, 16b), the top spacer region (16b) terminating with a p-layer (20) and a p⁺⁺/n⁺⁺ tunnel junction on top of said p-layer, each of the p⁺⁺- and p-layer presenting a p-type layer, at least the upper n⁺⁺-layer of the tunnel junction being a mesa (22) emerging from the underlying p-type layer, a structured surface (14b) of the active cavity material (14) being formed by an upper surface of the mesa (22) and an upper surface of the p-type layer outside the mesa (22);
- said active region is defined by a current aperture (25) including the mesa (22) surrounded by an air gap (24) between the fused structured surface of the active cavity material (14) and the surface of the n-type semiconductor layer of the top DBR stack (12b).

2. The device according to Claim 1, wherein said tunnel junction is positioned at a minimum of a standing wave optical field of the device structure and has a thickness of 20-50nm.

3. The device according to Claim 1, wherein the active cavity material (14) also comprises an electrical confining layer (28) in the cavity material outside the mesa (22).

4. The device according to Claim 3, wherein said confining layer (28) is an ion implantation layer.

5. The device according to Claim 1, and also comprising at least one additional active region sandwiched between the top and bottom DBRs (12a, 12b) to be formed with additional electrical contacts for an electric current flow therethrough between the active cavity material structure and the DBR stack, said at least one additional active region being defined by an additional mesa surrounded by an air gap between the fused structured surface of the active cavity material and the surface of the n-type semiconductor layer of the top DBR stack, the at least two active regions being aligned in a spaced-apart relationship.

6. The device according to Claim 5, wherein the at least two mesas have different heights, the at least two active regions being operable such that light emitted through the DBRs within the two active regions is of different wavelengths, respectively.

7. The device according to Claim 6, wherein said at least one additional mesa terminates with an additional n-type layer on top of the n⁺⁺ layer of the tunnel junction having a thickness not exceeding 1/8 of the emission wavelength inside the VCSEL structure.

8. The device according to Claim 7, wherein the additional n-type layer is composed of a certain number of pairs of layers, every pair having two layers of different chemical compositions.

9. The device according to Claim 8, wherein N such additional mesas are provided, each of the additional mesas containing the additional n-type layer of a different thickness, as compared to that of the other additional mesas.

10. The device according to Claim 9, wherein the difference between thickness values of the active cavity materials defined by each two locally adjacent active regions are equal, thereby providing an equal wavelength separation of the light emitted through the DBRs sandwiching each two locally adjacent active regions.

11. A method of fabrication of a vertical cavity surface emitting laser (VCSEL) device structure (10), the method comprising the steps of:
(i) growing a semiconductor active cavity material (14) including a multiquantum well layer stack (18) sandwiched between bottom and top spacer regions (16a, 16b) the top spacer region (16b) terminating with a p-layer (20) and a p⁺⁺/n⁺⁺ tunnel junction structure on top of said p-layer, each of the p⁺⁺- and p-layer presenting a p-type layer;
(ii) etching the active cavity material (14) formed in step (i) to form a mesa (22) including at least the upper n⁺⁺ layer of the tunnel junction emerging from the underlying p-type layer, thereby creating a structured surface (14b) of the active cavity material (14) formed by the upper surface of the mesa (22) and the upper surface of the p-type layer outside the mesa (22),
(iii) applying a wafer fusion between the structured surface (14b) of the active cavity material (14) and a substantially planar surface of a n-type semiconductor layer of a first Distributed Bragg Reflector (DBR) stack (12b), thereby causing deformation of the fused surface around the mesa and defining an aperture region (25) for electrical current flow therethrough, the aperture region (25) including the mesa (22) surrounded by an air gap (24) between the deformed fused surfaces and defining an active region of the device;
(iv) forming a second DBR stack (12a) on a surface of the active cavity material (14) opposite to the structured surface (14b),
(v) forming ohmic contacts (15) on the VCSEL device structure to enable the electrical current flow through the current aperture (25) to the active region (14).

12. The method according to Claim 11 wherein the active cavity material is grown on an InP substrate (26).

13. The method according to Claim 11, wherein said tunnel junction is positioned at a minimum of a standing wave optical field in the device structure and has a thickness of 20-50nm.

14. The method according to Claim 11, and also comprising the step of formation of an electrical confining layer (28) in the cavity material structure outside the mesa (22).

15. The method according to Claim 14, wherein the formation of the electrical confining layer (28) comprises ion implantation of the surface of the active cavity material (14) over the mesa (22) using photoresist discs as a mask, by locating the discs such as to be concentric with the mesa, thereby creating a ion implantation current confining layer that reaches an outer boundary of the air-gap and is located outside the active region.

16. The method according to Claim 11, and also comprising the step of formation of at least one additional active region sandwiched between the first and second DBRs (12a, 12b) starting from the active cavity material, and forming additional ohmic contacts on the VCSEL device structure to enable an electric current flow through the additional active region, said at least one additional active region including an additional mesa surrounded by an air gap between the fused structured surface of the active cavity material and the surface of the n-type semiconductor layer of the DBR stack.

17. The method according to Claim 16, wherein the formation of said at least one additional active region comprises the step of providing an additional n-type layer having a thickness not exceeding 1/8 of the emission wavelength inside the VCSEL structure, said etching being carried out in a manner to form said at least one additional mesa terminating with said additional n-type layer.

18. The method according to Claim 17, wherein said etching is carried out in a manner to form at least two additional mesas, each of the additional mesas containing a portion of said additional n-type layer of a thickness different to that of the other additional mesa.

19. The method according to Claim 11, wherein both DBRs (12a, 12b) are made of AlAs and GaAs layers.

20. The method according to Claim 11, wherein the second DBR stack (12a) is bonded to said surface of the active cavity material (14) by wafer fusion.

## Patentansprüche

1. Eine Vorrichtungsstruktur (10) eines vertikalen, einen Hohlraum umfassenden und an der Oberfläche emittierenden Lasers (VCSEL), welche eine Struktur (14) von halbleitenden aktiven Hohlraummaterial umfasst, die zwischen oberen und unteren Stapeln (12a, 12b) von verteilten Bragg Reflektoren (DBR) gelegen ist, der obere DBR (12b) enthält mindestens eine halbleitende Schicht vom n-Typ, und welche Vorrichtungsstruktur eine aktive Region zur Erzeugung von Licht in Antwort von Anwendung von direkter Spannung zu Vorrichtungskontakten (15) bestimmt, in welcher
- besagtes aktives Hohlraummaterial einen Stapel von Multiquantenschachtschichten (18) umfasst, welcher zwischen oberen und unteren Abstandsregionen (16a, 16b) gelegen ist, die obere Abstandsregion (16b) endet mit einer p-Schicht (20) und einer p⁺⁺/n⁺⁺ Tunnelverbindung auf der p-Schicht, jede von der p⁺⁺- und p-Schicht stellt eine Schicht von einem p-Typ dar, mindestens die obere n⁺⁺-Schicht von der Tunnelverbindung ragt als Tafelberg (22) aus der darunterliegenden Schicht vom p-Typ heraus, eine strukturierte Oberfläche (14b) von dem aktiven Hohlraummaterial (14) ist von einer oberen Oberfläche des Tafelbergs (22) und einer oberen Oberfläche von der Schicht vom p-Typ ausserhalb des Tafelbergs (22) geformt,
- die besagte aktive Region ist durch eine Stromöffnung (25) bestimmt, die den von einem Luftspalt zwischen der verschmolzenen strukturierten Oberfläche des aktiven Hohlraummaterials (14) und der Oberfläche der halbleitenden Schicht von n-Typ des oberen DBR-Stabels (12b) umgebenen Tafelberg enthält.

2. Die Vorrichtungsstruktur gemäss Anspruch 1, in welcher sich die besagte Tunnelverbindung an einem Minimum eines optischen Feldes einer stehenden Welle der Vorrichtungsstruktur befindet und eine Dicke von 20 bis 50nm aufweist.

3. Die Vorrichtungsstruktur gemäss Anspruch 1, in welcher das aktive Hohlraummaterial (14) eine elektrische begrenzenden Schicht (28) in dem Hohlraummaterial ausserhalb des Tafelberges umfasst.

4. Die Vorrichtungsstruktur gemäss Anspruch 3, in welcher die besagte begrenzende Schicht (28) eine Ionen implementierte Schicht ist.

5. Die Vorrichtungsstruktur gemäss Anspruch 1, und zusätzlich umfassend mindestens eine zusätzlich aktive Region zwischen den oberen und den unteren DBRs (12a, 12b), welche mit zusätzlichen elektrischen Kontakten zwischen der aktiven Hohlraumstruktur und dem DBR-Stapel für einen elektrischen Stromfluss dadurch ausgestattet ist, die besagte zusätzlich aktive Region ist bestimmt durch einen zusätzlichen Tafelberg, der von einem Luftspalt zwischen der verschmolzenen strukturierten Oberfläche des aktiven Hohlraummaterials und der Oberfläche der halbleitenden Schicht von n-Typ des oberen DBR-Stabels umgeben ist, die mindestens zwei aktiven Regionen sind beanstandet voneinander angeordnet.

6. Die Vorrichtungsstruktur gemäss Anspruch 5, in welcher die mindestens zwei Tafelberge unterschiedliche Höhen haben, die mindestens zwei aktive Regionen jeweils so betrieben werden können, dass durch die DBRs in den zwei aktiven Regionen emittiertes Licht unterschiedliche Wellenlängen hat.

7. Die Vorrichtungsstruktur gemäss Anspruch 6, in welcher der besagte mindestens eine zusätzliche Tafelberg mit einer zusätzlichen Schicht vom n-Typ auf der n⁺⁺-Schicht der Tunnelverbindung endet, deren Dicke 1/8 der emittierten Wellenlänge in der VCSEL-Struktur nicht überschreitet.

8. Die Vorrichtungsstruktur gemäss Anspruch 7, in welcher die zusätzliche Schicht vom n-Typ aus einer gewissen Nummer von Paaren von Schichten zusammen gesetzt ist, wobei jedes Paar zwei Schichten von unterschiedlicher chemischer Zusammensetzung hat.

9. Die Vorrichtungsstruktur gemäss Anspruch 8, in welcher N solcher zusätzlichen Tafelberge vorhanden sind, jeder der zusätzlichen Tafelberge enthält die zusätzliche Schicht vom n-Typ von unterschiedlicher Dicke im Vergleich mit derjenigen von den anderen Tafelbergen.

10. Die Vorrichtungsstruktur gemäss Anspruch 9, in welcher der Unterschied zwischen den Dickewerten des aktiven Hohlraummaterials festgelegt jeweils durch zwei sich nebeneinander befindende aktive Regionen gleich ist, dabei festlegend eine gleiche Trennung der Wellenlänge von Licht, welches durch die DBRs zwischen jeweils zwei sich nebeneinander befindenden aktiven Regionen ausgesandt wird.

11. Ein Verfahren zur Herstellung von einer Vorrichtungsstruktur (10) eines vertikalen, einen Hohlraum umfassenden und an der Oberfläche emittierenden Lasers (VCSEL), das Verfahren umfasst folgende Verfahrensschritte:
(i) Züchten eines halbleitenden aktiven Hohlraummaterials (14) mit einem Stapel von Multiquantenschachtschichten (18), der zwischen oberen und unteren Abstandsregionen (16a, 16b) gelegen ist, die obere Abstandsregion (16b) endet mit einer p-Schicht (20) und einer p⁺⁺/n⁺⁺ Tunnelverbindungsstruktur auf der besagten p-Schicht, wobei jede der p⁺⁺- und p-Schicht eine Schicht vom p-Typ darstellt;
(ii) Ätzen des aktiven Hohlraummaterials (14), welches in Schritt (i) gebildet wurde, um einen Tafelberg zu formen, welcher mindestens eine obere n⁺⁺ Schicht enthält, die aus der darunterliegenden Schicht vom p-Typ herausragt, wobei dabei eine strukturierte Oberfläche (14b) des aktiven Hohlraummaterials (14) geschaffen wird, geformt von einer oberen Oberfläche des Tafelbergs (22) und einer oberen Oberfläche von der Schicht vom p-Typ ausserhalb des Tafelbergs (22),
(iii) Anwendung einer Waferfusion zwischen der strukturierten Oberfläche (14b) des aktiven Hohlraummaterials (14) und einer im wesentlichen ebenen Oberfläche einer halbleitenden Schicht vom n-Typ eines ersten verteilten Bragg Reflektorsstapels (14b) (DBR), wobei eine Deformation von der verschmolzenen Oberfläche um den Tafelberg herum geschaffen wird und eine Öffnungsregion (25) zum Fluss eines elektrischen Stroms dadurch festgelegt wird, die Öffnungsregion (25) enthält den von einem sich zwischen den deformierten verschmolzenen Oberflächen befindenden Luftspalt (24) umgebenen Tafelberg (22) und legt eine aktive Region der Vorrichtung fest;
(iv) ein zweiter DBR-Stapel (12a) wird auf der Oberfläche des aktiven Hohlraummaterials (14) gegenüber der strukturierten Oberfläche (14b) geschaffen;
(v) ohmsche Kontakte (15) werden auf der VCSEL-Vorrichtungsstruktur angebracht, um einen Stromfluss durch die Stromöffnung (25) zu der aktiven Region (14) zu ermöglichen.

12. Das Verfahren gemäss Anspruch 11, in welchem das aktive Hohlraummaterial auf einem InP-Substrat (26) gezüchtet wird.

13. Das Verfahren gemäss Anspruch 11, in welchem sich die besagte Tunnelverbindung an einem Minimum eines optischen Feldes einer stehenden Welle der Vorrichtungsstruktur befindet und eine Dicke von 20 bis 50nm aufweist.

14. Das Verfahren gemäss Anspruch 11, welches zusätzlich den Schritt der Bildung einer elektrischen begrenzenden Schicht (28) in der Hohlraummateriafstruktur ausserhalb des Tafelberges enthält (22).

15. Das Verfahren gemäss Anspruch 14, im welchem zur Bildung der elektrischen begrenzenden Schicht (28) eine Ionenimplantation von der Oberfläche des aktiven Hohlraummaterials (14) oberhalb des Tafelberges (22) umfasst, wobei photoresistente Scheiben als Masken verwendet werden, die Bildung geschieht durch Plazieren der Scheiben derart, dass sie konzentrisch mit dem Tafelberg sind, wobei eine Ionenimplantationsschicht geschaffen wird, die an einen äusseren Rand des Luftspalts reicht und sich ausserhalb der aktiven Region befindet.

16. Das Verfahren gemäss Anspruch 11, und zusätzlich mit dem Schritt einer Bildung von mindestens einer zusätzlich aktiven Region gelegen zwischen dem ersten und dem zweiten DBR-Stapel (12a, 12b) beginnend von dem aktiven Hohlraummaterial, und der Bildung von ohmschen Kontakten auf der VCSEL-Vorrichtungsstruktur, um einen Stromfluss durch die zusätzlich aktive Region zu ermöglichen, die besagte mindestens eine zusätzlich aktive Region enthält einen zusätzlichen Tafelberg, der von einem Luftspalt zwischen der verschmolzenen strukturierten Oberfläche des aktiven Hohlraummaterials und der Oberfläche der halbleitenden Schicht vom n-Typ des DBR-Stapels umgeben ist.

17. Das Verfahren gemäss Anspruch 16, in welchem die Bildung von der besagten mindestens einen zusätzlichen Region den Schritt der Bereitstellung einer zusätzlichen Schicht vom n-Typ beinhaltet, deren Dicke 1/8 der emittierten Wellenlänge in der VCSEL-Struktur nicht überschreitet, das besagte Ätzen derart ausgeführt wird, dass mindestens ein zusätzlicher Tafelberg geschaffen wird, der mit der besagten zusätzlichen Schicht vom n-Typ endet.

18. Das Verfahren gemäss Anspruch 17, in weichem das Ätzen so ausgeführt wird, dass mindestens zwei zusätzliche Tafelberge geschaffen werden, jeder von diesen zusätzlichen Tafelbergen enthält einen Teil von der besagten zusätzlichen Schicht vom n-Typ mit einer anderen Dicke im Vergleich mit derjenigen des anderen zusätzlichen Tafelbergs.

19. Das Verfahren gemäss Anspruch 11, in welchem beide DBRs (12a, 12b) aus AIA- und GaAs-Schichten gemacht sind.

20. Das Verfahren gemäss Anspruch 11, in welchem der zweite DBR-Stapel (12a) an der besagten Oberfläche des aktiven Hohlraummaterials (14) durch Waferfusion gefestigt ist.

## Revendications

1. Structure de dispositif (10) à laser à cavité verticale émettant par la surface (VCSEL), comprenant une structure en matériau semiconducteur à cavité active (14), placée « en sandwich » entre des empilements supérieur et inférieur de Réflecteurs de Bragg Distribués (DBR) (12a, 12b), le DBR supérieur (12b) qui inclut au moins une couche de semiconducteur de type n, et définissant une zone active destinée à générer de la lumière en réponse à l'application d'une tension directe aux contacts (15) du dispositif, **caractérisée en ce que** :
- ledit matériau à cavité active comprend un empilement (18) de couches multiquantum placé « en sandwich » entre des zones d'espacement inférieure et supérieure (16a, 16b), la zone d'espacement supérieure (16b) se terminant par une couche p (20) et une jonction tunnel p⁺⁺/n⁺⁺ au dessus de ladite couche p, chacune des couches p et p⁺⁺ présentant une couche de type p, la couche n⁺⁺ supérieure, au moins, de la jonction tunnel étant un mésa (22) émergeant de la couche sous-jacente de type p, une surface structurée (14b) du matériau à cavité active (14) étant formée d'une surface supérieure du mésa (22) et d'une surface supérieure de la couche de type p extérieure au mésa (22),
- ladite zone active est définie par une ouverture de courant (25) incluant le mésa (22) entourée par un interstice d'air (24) entre la surface structurée fondue du matériau à cavité active (14) et la surface de la couche de semiconducteur de type n de l'empilement supérieur de DBR (12b).

2. Dispositif selon la revendication 1, **caractérisé en ce que** ladite jonction tunnel est placée à un minimum d'un champ optique à onde stationnaire de la structure du dispositif et présente une épaisseur de 20-50 nm.

3. Dispositif selon la revendication 1, **caractérisé en ce que** le matériau à cavité active (14) comprend également une couche électrique de confinement (28) dans le matériau à cavité, à l'extérieur du mésa (22).

4. Dispositif selon la revendication 3, **caractérisé en ce que** ladite couche de confinement (28) est une couche à implantation ionique.

5. Dispositif selon la revendication 1, et comprenant également au moins une zone active supplémentaire placée « en sandwich » entre les DBRs supérieur et inférieur (12a, 12b) et munie de contacts électriques supplémentaires destinés à être traversés par un flux de courant électrique entre la structure de matériau à cavité active et l'empilement de DBR, ladite au moins une zone active supplémentaire étant définie par un mésa supplémentaire entouré d' un gap d'air entre la surface structurée fondue du matériau à cavité active et la surface de la couche de semiconducteur de type n de l'empilement supérieur de DBR, les au moins deux zones actives étant alignées de manière espacée.

6. Dispositif selon la revendication 5, **caractérisé en ce que** les au moins deux mésas possèdent des hauteurs différentes, les au moins deux zones actives fonctionnant de manière à ce que la lumière émise à travers les DBRs dans les deux zones actives possède respectivement des longueurs d'onde différentes.

7. Dispositif selon la revendication 6, **caractérisé en ce que** ledit au moins un mésa supplémentaire se termine par une couche supplémentaire de type n au dessus de la couche n⁺⁺ de la junction tunnel, dont l'épaisseur n'excède pas 1/8^{ème} de la longueur d'onde d'émission à l'intérieur de la structure du VCSEL.

8. Dispositif selon la revendication 7, **caractérisé en ce que** la couche de type n supplémentaire est composée d'un certain nombre de paires de couches, chaque paire ayant deux couches de compositions chimiques différentes.

9. Dispositif selon la revendication 8, **caractérisé en ce que** N tels mésas supplémentaires sont prévus, chacun des mésas supplémentaires contenant la couche supplémentaire de type n d'une épaisseur différente comparativement à celle des autres couches supplémentaires.

10. Dispositif selon la revendication 9, **caractérisé en ce que** la différence entre les valeurs d'épaisseur des matériaux à cavité active définie par les deux zones actives localement adjacentes sont égales, permettant ainsi d'obtenir une séparation de longueurs d'onde égale de la lumière émise à travers les DBR plaçant en sandwich chacunes des deux zones actives localement adjacentes.

11. Procédé de fabrication d'une structure de dispositif de laser à cavité active émettant par la surface (VCSEL) (10), le procédé comprenant les étapes consistant à:
(i) faire croître un matériau semiconducteur à cavité active (14) incluant un empilement (18) de couches multipuits placé « en sandwich » entre des zones d'espacement inférieure et supérieure (16a, 16b), la zone supérieure d'espacement (16b) se terminant par une couche p (20) et une structure à jonction tunnel p⁺⁺/n⁺⁺ au dessus de ladite couche p, chacune des couches p et p⁺⁺ présentant une couche de type p ;
(ii) graver le matériau à cavité active (14) formé à l'étape (i) pour former un mésa (22) incluant au moins la couche n⁺⁺ supérieure de la jonction tunnel émergeant de la couche de type p sous-jacente, créant ainsi une surface structurée (14b) du matériau à cavité active (14) formée par la surface supérieure du mésa (22) et la surface supérieure de la couche de type p extérieure au mésa (22) ;
(iii) appliquer une fusion de galette entre la surface structurée (14b) du matériau à cavité active (14) et une surface essentiellement plane d'une couche de semiconducteur de type n d'un premier empilement de Réflecteurs de Bragg Distribués (DBR) (12b), causant ainsi la déformation de la surface fondue autour du mésa et définissant une zone d'ouverture (25) destinée à être traversée par un flux de courant électrique, la zone d'ouverture (25) incluant le mésa (22) entouré par un interstice d'air (24) entre les surfaces fondues déformées et définissant une zone active du dispositif ;
(iv) former un second empilement de DBRs (12a) sur une surface du matériau à cavité active (14) opposée à la surface structurée (14b) ;
(v) former des contacts ohmiques (15) sur la structure du dispositif VCSEL afin de permettre aux flux de courant électrique de traverser l'ouverture de courant (25) vers la zone active (14).

12. Procédé selon la revendication 11 **caractérisé en ce que** la croissance du matériau à cavité active se fait sur un substrat InP (26).

13. Procédé selon la revendication 11, **caractérisé en ce que** ladite jonction tunnel est placée à un minimum d'un champ optique à onde stationnaire de la structure du dispositif et présente une épaisseur de 20-50 nm.

14. Procédé selon la revendication 11, et comprenant également l'étape consistant à former une couche électrique de confinement (28) dans la structure du matériau à cavité à l'extérieur du mésa (22).

15. Procédé selon la revendication 14, **caractérisé en ce que** la formation de la couche électrique de confinement (28) comprend une implantation ionique à la surface du matériau à cavité active (14) au dessus du mésa (22) en utilisant des disques photorésisants comme masque, en plaçant les disques de manière concentrique avec le mésa, créant ainsi une couche de confinement du courant d'implantation ionique qui atteint une limite externe du gap d'air et est située à l'extérieur de la zone active.

16. Procédé selon la revendication 11, et comprenant également l'étape consistant à former au moins une zone active supplémentaire placée en sandwich entre les premier et second BDR (12a, 12b) débutant du matériau à cavité active, et à former des contacts ohmiques (15) sur la structure du dispositif VCSEL afin de permettre au flux de courant électrique de traverser la zone active supplémentaire, ladite au moins une zone active supplémentaire incluant un mésa supplémentaire entouré d'un interstice d'air entre la surface structurée fondue du matériau à cavité active et la surface de la couche de semiconducteur de type n de l'empilement de DBR.

17. Procédé selon la revendication 16, **caractérisé en ce que** la formation de ladite au moins une zone active supplémentaire comprend l'étape de prévoir une couche supplémentaire de type n dont l'épaisseur n'excède pas 1/8^{ème} de la longueur d'onde d'émission à l'intérieur de la structure du VCSEL, ladite étape de gravure étant effectuée de manière à former ledit au moins un mésa supplémentaire se terminant par ladite couche supplémentaire de type n.

18. Procédé selon la revendication 17, **caractérisé en ce que** l'étape de gravure est effectuée de manière à former au moins deux mésas supplémentaires, chacun des mésas supplémentaires contenant une partie de ladite couche supplémentaire de type n d'une épaisseur différente de celle de l'autre mésa supplémentaire.

19. Procédé selon la revendication 11, **caractérisé en ce que** les deux DBR (12a, 12b) sont faits de couches de AlAs et de GaAs.

20. Procédé selon la revendication 11, **caractérisé en ce que** le second empilement de DBR (12a) est lié à ladit surface dudit matériau à cavité active (14) par fusion de galette.
